# EUROPÄISCHE PATENTSCHRIFT

(11) **EP 1 400 857 B1**
(45) Veröffentlichungstag und Bekanntmachung des Hinweises auf die Patenterteilung: **25.08.2004**
(21) Anmeldenummer: 03005894.5
(22) Anmeldetag: 17.03.2003
(51) Int. Cl.: G03F 7/36, G03F 7/033

(54) **Verfahren zur Herstellung von Flexodruckformen durch thermische Entwicklung**
A process for making a flexographic printing plate by thermal development
Procédé de fabrication de plaques flexographiques par développement thermique

(30) Priorität: 09.09.2002 DE 10241851
(43) Veröffentlichungstag der Anmeldung: 24.03.2004
(73) Patentinhaber: BASF Drucksysteme GmbH, 70469 Stuttgart (DE)
(72) Erfinder: Schadebrodt, Jens, Dr., 55129 Mainz (DE); Hiller, Margit, Dr., 97753 Karlstadt (DE)
(74) Vertreter: Poganiuch, Peter

(56) Entgegenhaltungen:
- EP-A- 0 468 745
- JP-A- 4 067 041
- US-A- 5 344 881

## Beschreibung

Die Erfindung betrifft ein Verfahren zur Herstellung von Flexodruckformen durch thermische Entwicklung, bei dem man ein bildweise belichtetes Flexodruckelelement durch Erwärmen und Entfernen der erweichten, nicht polymerisierten Anteile der reliefbildenden Schicht entwickelt, wobei das eingesetzte Flexodruckelement ein Olefin/(Meth)acrylat-Copolymerenthält, welches als Monomere 70 bis 92 mol % Olefin-Monomere, 8 bis 30 mol % (Meth)acrylat-Monomere sowie 0 - 5 mol % weitere Comonomere aufweist. Die Erfindung betrifft weiterhin ein fotopolymerisierbares Flexodruckelement, welches die besagten Olefin(Meth)acrylat-Copolymere enthält, sowie die Verwendung dieses Flexodruckelementes zur Herstellung von Flexodruckformen sowohl durch thermische Entwicklung wie durch Entwicklung mittels Auswaschmitteln.

Das am weitesten verbreitete Verfahren zur Herstellung von Flexodruckformen umfasst die bildmäßige Belichtung der fotopolymerisierbaren reliefbildenden Schicht durch eine fotografische oder digital erstellte Maske. In einem weiteren Verfahrensschritt wird die belichtete Schicht mit einem geeigneten Lösemittel bzw. Lösemittelgemisch behandelt, wobei die unbelichteten, nicht polymerisierten Bereiche der fotopolymerisierbaren Schicht entfernt werden, während die belichteten, polymerisierten Bereiche erhaltenen bleiben und das Relief der Druckplatte bilden. Der Auswaschprozess benötigt jedoch eine längere Zeitspanne. Weiterhin werden die polymerisierten Schichtbestandteile zwar nicht gelöst, aber sie quellen gleichwohl im Auswaschmittel. Die Platte muss daher nach dem Auswaschen noch sorgfältig getrocknet werden, bevor sie zum Druck verwendet werden kann. Der Trockenprozess kann mehrere Stunden dauern.

Als Alternative zur Entwicklung mittels Lösemitteln ist von US 3,264,103, US 5,175,072, WO 96/14603 oder WO 01/88615 die thermische Entwicklung vorgeschlagen worden.

Bei der thermischen Entwicklung wird kein Lösemittel eingesetzt. Statt dessen wird die reliefbildende Schicht nach der bildmäßigen Belichtung mit einem absorbierenden Material in Kontakt gebracht und erwärmt. Bei dem absorbierenden Material handelt es sich beispielsweise um ein poröses Vlies, beispielsweise aus Nylon, Polyester, Cellulose oder anorganischen Materialien. Durch das Erwärmen verflüssigen sich die nicht polymerisierten Anteile der reliefbildenden Schicht und werden vom Vlies aufgesogen. Das vollgesogene Vlies wird anschließend entfernt.

Anstelle der Verwendung von absorbierenden Materialien zur Entfernung der verflüssigten Masse ist von WO 01/90818 als Alternative vorgeschlagen worden, das belichtete Flexodruckelement mit einem heißen Luft- oder Flüssigkeitsstrom unter Druck zu behandeln und somit die nicht polymerisierten Anteile zu entfernen.

Als bevorzugte Materialien für Flexodruckelemente zur thermischen Entwicklung sind von EP-A 468 745 elastomere Polyurethane vorgeschlagen worden, wenngleich diese Schrift auch einige kommerziell erhältliche, zur Entwicklung mit Lösemitteln vorgesehene, Flexodruckelemente als prinzipiell geeignet bezeichnet.

WO 01/88615 bekräftigt allerdings, dass kommerziell erhältliche, zur Entwicklung mit Lösemitteln vorgesehene, Flexodruckelemente häufig nicht zur thermischen Entwicklung geeignet sind, und schlägt statt dessen Flexodruckelente vor, deren reliefbildende Schicht bestimmte dynamisch-mechanische Kennwerte aufweist. Olefin / (Meth)acrylat-Copolymere werden nicht als mögliche Bindemittel offenbart.

Zur Durchführung der thermischen Entwicklung geeignete Geräte sind von EP-A 469 735 und WO 01/18604 vorgeschlagen worden und sind unter dem Namen Cyrel® Fast auch kommerziell erhältlich.

JP-A 04-67041 offenbart ein fotoempfindliches Flexodruckelement, welches ein Copolymer aus 10 bis 80 mol % konjugierten Diolefinen, 5 - 40 mol % saure Gruppen aufweisenden (Meth)acrylaten, 0 - 80 mol % Monoolefinen sowie 0 - 5 mol % polyfunktionelle Vinylverbindungen als Monomerbausteinen umfasst. Das Flexodruckelement ist zur Entwicklung mit wässrig-alkalischen Entwicklern vorgesehen. Thermische Entwicklung ist von der Schrift nicht offenbart.

Trotz der prinzipiellen Eignung der thermischen Entwicklung zur Herstellung von Flexodruckformen sieht sich der Fachmann bei der Umsetzung des Konzeptes einer Vielzahl von Problemen gegenüber, so dass die thermische Entwicklung bislang am Markt nur eine untergeordnete Rolle spielt und die Entwicklung mittels Lösemittel bislang keineswegs ersetzen kann. Insbesondere die Herstellung von hochauflösenden Platten in gleichbleibender Qualität und die Herstellung von Platten mit großen Relieftiefen bereiten bislang immer noch Probleme.

Bei der thermischen Entwicklung sollte das nicht polymerisierte Material möglichst gut verflüssigt werden, um eine effiziente und vollständige Entfernung zu ermöglichen. Auf dem Druckrelief verbleibende Ablagerungen führen zumindest zu verringerter Auflösung und zu einem unsauberen, qualitativ minderwertigen Druckbild. Feine Reliefelemente werden unter Umständen stark deformiert oder überhaupt nicht mehr ausgebildet.

Hier befindet sich der Fachmann in einer typischen Scherensituation. Einerseits wird die gute Verflüssigung des zu entfernenden Materials naturgemäß durch höhere Temperaturen begünstigt. Je dünnflüssiger, desto besser und desto schneller wird das verflüssigte polymere Material vom Vlies aufgesogen. Nachteiligerweise leidet mit zunehmender Temperatur die Dimensionsstabilität der Trägerfolie. Durch Verziehen der Trägerfolie wird die Passergenauigkeit der Druckplatte schlechter. Auch können - insbesondere feine - Reliefelemente durch zu hohe Temperatur verformt oder zerstört werden. Weiterhin ist die Druckplatte im Zuge des Andrückens oder Anpressens des Vlieses auch einer gewissen mechanischen Belastung ausgesetzt, die das Druckrelief in Verbindung mit der Temperaturbelastung erheblich schädigen kann.

Zur Lösung dieses Problems ist von WO 96/14603 vorgeschlagen worden, Folien mit einer besonders guten Dimensionsstabilität einzusetzen, beispielsweise solche aus PEN. Derartige Folien sind jedoch teuer und haben außerdem keinen Einfluss auf die Belastung der Reliefelemente selbst.

Zur Erleichterung der Verflüssigung kann der Fachmann auch nicht beliebig leichter erweichende Polymere einsetzen, denn durch die Art des Polymers werden selbstverständlich auch die elastischen und die drucktypischen Eigenschaften der Druckform beeinflusst. Zudem sind sehr weiche, plastische Reliefdruckformen zum Flexodruck ungeeignet.

Von Kunden wird weiterhin häufig verlangt, dass Flexodruckelemente sowohl zur thermischen wie zur Entwicklung mittels Lösemitteln geeignet sein sollen.

Aufgabe der Erfindung war es daher, ein Verfahren zur Herstellung von Flexodruckformen mittels thermischer Entwicklung sowie dazu geeignete Flexodruckelemente zur Verfügung zustellen, welches die obigen Nachteile nicht aufweist. Die thermische Entwicklung sollte bei möglichst tiefen Temperaturen durchgeführt werden können aber dennoch ausreichend schnell sein und ein qualitativ hochwertiges Druckrelief ergeben. Weiterhin sollte das Flexodrukkelement eine Doppelfunktion erfüllen können, nämlich sowohl thermisch wie auch mittels gängigen organischen Auswaschmitteln in vergleichbarer Qualität entwickelbar sein.

Dementsprechend wurde ein Verfahren zur Herstellung von Flexodruckformen durch thermische Entwicklung gefunden, bei dem man als Ausgangsmaterial ein fotopolymerisierbares Flexodruckelement einsetzt, welches übereinander angeordnet mindestens umfasst
- einen dimensionsstabilen Träger,
- mindestens eine fotopolymerisierbare, reliefbildende Schicht, mindestens umfassend ein elastomeres Bindemittel, Monomere und Fotoinitiator,
und das Verfahren mindestens die folgenden Schritte umfasst:
(a) bildweises Belichten der fotopolymerisierbaren reliefbildenden Schicht mittels aktinischer Strahlung,
(b) Erwärmen des belichteten Flexodruckelementes auf eine Temperatur von 40 bis 200°C,
(c) Entfernen der erweichten, nicht polymerisierten Anteilen der reliefbildenden Schicht unter Ausbildung eines Druckreliefs,
wobei es sich bei dem elastomeren Bindemittel um ein Olefin/(Meth)acrylat-Copolymer handelt, welches
- 70 bis 92 mol % eines oder mehrerer Olefin-Monomere, auswählt aus der Gruppe von Ethylen, Propylen, 1-Buten, Isobuten, 1-Penten, 1-Hexen, 1-Hepten oder 1-Octen,
- 8 bis 30 mol % (Meth)acrylat-Monomere, sowie
- 0 bis 5 mol % weiterer Copolymerer
jeweils bezüglich der Gesamtmenge aller einpolymerisierten Monomere aufweist.

In einem zweiten Aspekt der Erfindung wurde ein fotopolymerisierbares Flexodruckelement gefunden, dessen reliefbildende Schicht ein Olefin/(Meth)acrylat-Copolymer der geschilderten Art umfasst.

In einem dritten Aspekt der Erfindung wurde die Verwendung dieses Flexodruckelementes zur Herstellung von Flexodruckformen, insbesondere durch thermische Entwicklung oder Entwicklung mit Hilfe eines Lösemittels gefunden.

Überraschenderweise wurde gefunden, dass mit dem erfindungsgemäßen Verfahren Flexodruckformen hervorragender Qualität erhalten werden. Das nicht polymerisierte Material lässt sich thermisch hervorragend entfernen, ohne dass Reste auf den Reliefelementen zurückbleiben oder Reliefelemente beschädigt werden. Die Temperaturbelastung des Elementes im Zuge des Verfahrens ist so niedrig, dass auch bei Verwendung üblicher PET-Folien gute Resultate erzielt werden. Die erfindungsgemäßen Flexodruckelemente sind weiterhin gleichermaßen gut thermisch und mittels Auswaschmitteln entwickelbar.

Zu der Erfindung ist im Einzelnen das Folgende auszuführen:

Beispiele geeigneter dimensionsstabiler Träger für das als Ausgangsmaterial für das Verfahren eingesetzten fotopolymerisierbaren Flexodruckelement sind Platten, Folien sowie konische und zylindrische Röhren (Sleeves) aus Metallen wie Stahl, Aluminium, Kupfer oder Nickel oder aus Kunststoffen wie Polyethylenterephthalat (PET), Polyethylennaphthalat (PEN), Polybutylenterephthalat, Polyamid, Polycarbonat, gegebenenfalls auch Gewebe und Vliese, wie Glasfasergewebe sowie Verbundmaterialien, z.B. aus Glasfasern und Kunststoffen. Als dimensionsstabile Träger kommen vor allem dimensionsstabile Trägerfolien wie beispielsweise Polyesterfolien, insbesondere PET- oder PEN-Folien oder flexible metallische Träger, wie dünne Bleche oder Metallfolien aus Stahl, bevorzugt aus rostfreiem Stahl, magnetisierbarem Federstahl, Aluminium, Zink, Magnesium, Nickel, Chrom oder Kupfer in Betracht.

Das Flexodruckelement umfasst weiterhin mindestens eine fotopolymerisierbare, reliefbildende Schicht. Die fotopolymerisierbare reliefbildende Schicht kann unmittelbar auf dem Träger aufgebracht sein. Zwischen dem Träger und der reliefbildende Schicht können sich aber auch noch andere Schichten befinden, wie beispielsweise Haftschichten und/oder elastische Unterschichten.

Die fotopolymerisierbare reliefbildende Schicht umfasst mindestens ein elastomeres Bindemittel, ethylenisch ungesättigte Monomere, einen Fotoinitiator oder ein Fotoinitiatorsystem sowie optional weitere Komponenten.

Bei dem mindestens einen elastomeren Bindemittel handelt es sich um ein Olefin/(Meth)acrylat-Copolymer, welches einen Olefingehalt von 70 bis 92 mol % bezüglich der Gesamtmenge aller einpolymerisierten Monomere aufweist. Bevorzugt beträgt der Olefin-Gehalt 80 bis 90 mol %.

Der Schmelzflussindex MFI (190°C, 2,16 kg), gemessen gemäß ASTM D 1238 des Olefin/Meth(acrylat)-Copolymers beträgt im Regelfalle 0,5 bis 100 g/10 min, bevorzugt 1 bis 100 g / 10 min. In besonderen Fällen können aber auch außerhalb dieses Bereiches noch zufriedenstellende Ergebnisse erzielt werden. Besonders bevorzugt beträgt der MFI (190°C, 2,16 kg) 2 bis 50 g / 10 min und ganz besonders bevorzugt 3 bis 10 g / 10 min.

Das Copolymere umfasst als olefinische Monomerbausteine Olefine mit 2 bis 8 C-Atomen wie beispielsweise Ethylen, Propylen, 1-Buten, Isobuten, 1-Penten, 1-Hexen, 1-Hepten oder 1-Octen. Selbstverständlich können auch Gemische verschiedener Olefine enthalten sein. Besonders bevorzugt sind Olefine mit 2 bis 4 C-Atomen, und ganz besonders bevorzugt ist Ethylen. Bei den besonders bevorzugten Ethylen / (Meth)acrylat-Copolymeren kann es sich um solche handeln, die ausschließlich Ethylen als olefinisches Monomer enthalten. Es kann sich aber auch um solche handeln, bei denen Ethylen den Hauptbestandteil der Olefine bildet und andere Olefine, insbesondere die besagten C₂ bis C₈-Olefine, in geringen Mengen als Comonomere mit einpolymerisiert werden.

Als Comonomere zu den Olefinen werden Acrylsäure- und/oder Methacrylsäureester eingesetzt. Geeignet sind insbesondere (Meth)acrylate mit geradkettigen oder verzeigten C₁ bis C₁₂-Alkylresten, bevorzugt C₁ bis C₈-Alkylresten. Beispiele umfassen Methyl-, Ethyl-, n-Propyl, i-Propyl, n-Butyl, i-Butyl, n-Hexyl, 2-Ethylhexyl, n-Octyl, 2-Ethyloctyl, n-Decyl oder n-Dodecylreste. Die Alkylreste können auch noch weiter substituiert sein und/oder funktionelle Gruppen aufweisen, vorausgesetzt, die Eigenschaften der reliefbildende Schicht werden dadurch nicht negativ beeinflusst. Als funktionelle Gruppen bewährt haben sich beispielsweise Epoxygruppen. Geeignet als funktionalisierte Alkylreste sind insbesondere Glycidylreste.

Bevorzugte Comonomere sind Methyl(meth)acrylat, Ethyl(meth)acrylat, n-Butyl(meth)acrylat, Ethylhexyl(meth)acrylat oder Glycidyl(meth)acrylat. Selbstverständlich können auch Gemische mehrerer (Meth)acrylate als Comonomer eingesetzt werden. Beispielsweise kann ein Gemisch aus Glycidyl(meth)acrylat mit Methyl-, Ethyl- oder Butyl(meth)acrylat eingesetzt werden.

Die Menge an (Meth)acrylat-Comonomeren beträgt im Regelfalle 8 bis 30 mol % bezüglich der Gesamtmenge aller in das Copolymer einpolymerisierten Monomere, bevorzugt 10 bis 20 mol %.

Zur Feinsteuerung der Eigenschaften des erfindungsgemäß verwendeten Copolymeren können neben den Olefinen und (Meth)acrylaten noch weitere ethylenisch ungesättigte Gruppen aufweisende Comonomere anwesend sein, vorausgesetzt, die Eigenschaften der reliefbildende Schicht werden dadurch nicht negativ beeinflusst. Beispiele geeigneter Comonomerer umfassen Maleinsäureanhydrid, (Meth)acrylsäure, Maleinsäure und deren (Halb-)Ester, Fumarsäure und deren (Halb-)Ester, Vinyllactame, Vinylamide, Vinylhalogenide, Vinylester, Vinylether, Vinylsilane und Vinylsiloxane. Besonders bevorzugtes weiteres Comonomer ist Maleinsäureanhydrid. Die Menge derartiger Comonomerer sollte jedoch im Regelfalle die Menge von 5 mol % bezüglich der Gesamtmenge aller im Olefin/(Meth)acrylat-Copolymeren enthaltenen Monomere nicht überschreiten.

Bevorzugt handelt es sich bei den Ethylen / (Meth)acrylat-Copolymeren um statistische Copolymere. Sie sind beispielsweise unter dem Namen Lotryl® oder Lotader® kommerziell erhältlich. Selbstverständlich können auch Gemische von zwei oder mehreren verschiedenen Ethylen / (Meth)acrylat-Copolymeren eingesetzt werden. Neben dem mindestens einen Ethylen / (Meth)acrylat-Copolymeren kann die reliefbildende Schicht optional noch eines oder mehrere sekundäre Bindemittel aufweisen. Derartige sekundäre Bindemittel können vom Fachmann zur Feinsteuerung der Eigenschaften der späteren Druckform eingesetzt werden. Beispielsweise lassen sich die Elastizität oder die Farbannahme der Druckform beeinflussen. Beispiele geeigneter sekundärer Bindemittel umfassen Ethylen-Propylen-Dien-Terpolymere, Ethylen-Octen-Copolymere, Ethylen-Vinylacetat-Copolymere, Nitrilkautschuk, Naturkautschuk, Butylkautschuk, Polyisobutylen, Polyisopren, Polybutadien, Polychloropren, Styrol-Dien-Blockcopolymere, hydrierte Styrol-Dien-Blockcopolymere, Polyvinylbutyral oder Styrol-Butadien-Emulsionscopolymere. Die Auswahl sekundärer Bindemittel ist prinzipiell nicht beschränkt, solange die Eigenschaften der reliefbildenden Schicht dadurch nicht beeinträchtigt werden. Insbesondere sollten Art und Menge sekundärer Bindemittel so gewählt werden, dass die reliefbildende Schicht eine ausreichende Transparenz aufweist. Die Menge an sekundären Bindemitteln sollte aber im Regelfalle 20 Gew.-%, bevorzugt 10 Gew.-% und besonders bevorzugt 5 Gew.-% bezüglich der Gesamtmenge aller eingesetzten Bindemittel nicht überschreiten.

Die Gesamtmenge an Bindemitteln, also Olefin / (Meth)acrylat-Copolymeren und eventuell vorhandenen sekundären Bindemitteln zusammen, beträgt üblicherweise 40 bis 95 Gew.-% bezüglich der Summe aller Bestandteile der reliefbildenden Schicht, bevorzugt 50 bis 85 Gew.-% und besonders bevorzugt 60 bis 80 Gew.-%.

Die fotopolymerisierbare reliefbildende Schicht umfasst weiterhin in bekannter Art und Weise polymerisierbare Verbindungen, beziehungsweise Monomere. Die Monomeren sollen mit dem Olefin / (Meth)acrylat-Copolymeren verträglich sein und mindestens eine polymerisierbare, ethylenisch ungesättigte Doppelbindung aufweisen. Als besonders vorteilhaft haben sich Ester oder Amide der Acrylsäure oder Methacrylsäure mit mono- oder polyfunktionellen Alkoholen, Aminen, Aminoalkoholen oder Hydroxyethern und -estern, Ester der Fumar- oder Maleinsäure oder Allylverbindungen erwiesen. Beispiele für geeignete Monomere sind Butylacrylat, 2-Ethylhexylacrylat, Laurylacrylat, 1,4-Butandioldiacrylat, 1,6-Hexandioldiacrylat, 1,6-Hexandioldimethacrylat, 1,9-Nonandioldiacrylat, Trimethylolpropantri(meth)acrylat, Dioctylfumarat, N-Dodecylmaleimid. Die Menge an Monomeren in der reliefbildenden Schicht beträgt in der Regel 4,9 bis 30 Gew.-% bzgl. der Menge aller Bestandteile, bevorzugt 4,9 bis 20 Gew.-%.

Die fotopolymerisierbare reliefbildende Schicht weist weiterhin in prinzipiell bekannter Art und Weise einen Fotoinitiator oder ein Fotoinitiatorsystem auf. Beispiele für geeignete Initiatoren sind Benzoin oder Benzoinderivate, wie Methylbenzoin oder Benzoinether, Benzilderivate, wie Benzilketale, Acylarylphosphinoxide, Acylarylphosphinsäureester, Mehrkernchinone oder Benzophenone. Die Menge an Fotoinitiator in der reliefbildenden Schicht beträgt in der Regel 0,1 bis 5 Gew.-% bzgl. der Menge aller Bestandteile der reliefbildenden Schicht.

Die reliefbildende Schicht kann optional einen Weichmacher umfassen. Es können auch Gemische verschiedener Weichmacher eingesetzt werden. Beispiele für geeignete Weichmacher umfassen modifizierte und unmodifizierte Naturöle und -harze, wie hochsiedende paraffinische, naphthenische oder aromatische Mineralöle, synthetische Oligomere oder Harze wie Oligostyrol, hochsiedende Ester, oligomere Styrol-Butadien-Copolymere, oligomere α-Methylstyrol/pthylstyrol-Copolymere, flüssige Oligobutadiene, insbesondere solche mit einem Molekulargewicht zwischen 500 und 5000 g/mol, oder flüssige oligomere Acrylnitril-Butadien-Copolymere oder oligomere Ethylen-Propylen-Dien-Copolymere. Bevorzugt sind vinylgruppenreiche Polybutadienöle, hochsiedende aliphatische Ester und Mineralöle. Besonders bevorzugt sind hochsiedende, im wesentlichen paraffinische und / oder naphthenische Mineralöle. Zum Beispiel sind sogenannte paraffinbasische Solvate und Spezialöle unter den Namen Shell Catenex S und Shell Catenex PH kommerziell erhältlich. Der Fachmann unterscheidet bei Mineralölen technische Weißöle, die noch einen sehr geringen Aromatengehalt aufweisen können, sowie medizinische Weißöle, die im wesentlichen aromatenfrei sind. Sie sind kommerziell erhältlich, beispielsweise unter den Namen Shell Risella (technisches Weißöl) oder Shell Ondina (medizinisches Weißöl).

Weiterhin sind auch bestimmte synthetische Weichmacher wie etwa peralkylierte Aromaten, die frei an gesundheitsschädlichen Aromaten sind, als Weichmacher geeignet. Derartige synthetische Weichmacher, häufig mit Weißölen gestreckt, sind beispielsweise unter dem Namen Kettlitz Mediaplast erhältlich.

Die Menge eines optional vorhandenen Weichmachers wird vom Fachmann je nach den gewünschten Eigenschaften der Schicht bestimmt. Sie sollte aber im Regelfalle 40 Gew.-% bevorzugt 30 Gew.-% bezüglich der Summe aller Bestandteile der fotopolymerisierbaren reliefbildende Schicht nicht übersteigen. Falls ein Weichmacher vorhanden ist, haben sich Mengen von 5 bis 30 Gew.-%, bevorzugt 10 bis 25 Gew.-% bewährt.

Die reliefbildende Schicht kann optional weitere Bestandteile wie beispielsweise Inhibitoren für die thermisch initiierte Polymerisation, Farbstoffe, Pigmente, fotochrome Zusätze oder Antioxidantien umfassen. Im Regelfalle sollten aber nicht mehr als 10 Gew.-% bezüglich der Summer aller Bestandteile der Schicht, bevorzugt nicht mehr als 5 Gew.-% eingesetzt werden.

Bei der fotopolymerisierbaren reliefbildenden Schicht kann es sich auch um mehrere fotopolymerisierbare Schichten übereinander handeln, die eine gleiche, annährend gleiche oder verschiedene Zusammensetzung aufweisen. Ein mehrschichtiger Aufbau hat den Vorteil, dass die Eigenschaften der Oberfläche der Druckform, wie beispielsweise Farbübertragung verändert werden können, ohne die flexotypischen Eigenschaften der Druckform wie beispielsweise Härte oder Elastizität zu beeinflussen. Oberflächeneigenschaften und Schichteigenschaften können also unabhängig voneinander verändert werden, um ein optimales Druckergebnis zu erreichen.

Das Flexodruckelement kann neben der reliefbildenden Schicht optional noch weitere Schichten umfassen.

Beispiele derartiger Schichten umfassen eine elastomere Unterschicht aus einer anderen Formulierung, die sich zwischen dem Träger und der bzw. den reliefbildenden Schicht(en) befindet. Mit derartigen Unterschichten können die mechanischen Eigenschaften der Flexodruckplatten verändert werden, ohne die Eigenschaften der eigentlichen druckenden Reliefschicht zu beeinflussen.

Dem gleichen Zweck dienen sogenannte elastische Unterbauten, die sich unter dem dimensionsstabilen Träger des Flexodruckelementes befinden, also auf der von der reliefbildenden Schicht abgewandten Seite des Trägers.

Weitere Beispiele umfassen Haftschichten, die den Träger mit darüber liegenden Schichten oder verschiedene Schichten untereinander verbinden.

Die Dicke der reliefbildenden Schicht(en) wird vom Fachmann je nach dem gewünschten Verwendungszweck der Flexodruckform bestimmt und beträgt im Regelfalle 0,5 bis 7 mm, bevorzugt 0,5 bis 5 mm und besonders bevorzugt 0,7 bis 2,5 mm.

Das fotopolymerisierbare Flexodruckelement kann weiterhin eine lichtdurchlässige, nicht klebrige Deckschicht aufweisen. Derartige Deckschichten sind auch als Substratschichten oder als release-layer bekannt. Sie erleichterten das Abziehen einer eventuell vorhandenen Schutzfolie vor dem Gebrauch des Flexodruckelementes und vermeiden so eine Beschädigung der reliefbildenden Schicht. Sie erleichtern weiterhin das Auflegen und Abnehmen des fotografischen Negativs zur Bebilderung. Substratschichten werden von einem reissfeste Filme bildenden Polymeren und den gegebenenfalls darin enthaltenen Zusatzstoffen gebildet. Beispiele geeigneter, reissfester Filme bildender Polymerer sind Polyamide, voll- oder teilverseifte Polyvinylacetate oder Polyethylenoxid/Vinylacetat-Pfropfpolymerisate. Im allgemeinen sind die Substratschichten 0,2 bis 25 µm dick, bevorzugt beträgt die Dicke 2 bis 20 µm.

Das als Ausgangsmaterial eingesetzte Flexodruckelement kann optional noch durch eine Schutzfolie, beispielsweise eine Schutzfolie aus PET, vor Beschädigungen geschützt werden, die sich auf der jeweils obersten Schicht des Flexodruckelements, also im Regelfalle auf der Substratschicht, befindet. Falls das fotoempfindliche Flexodruckelement eine Schutzfolie aufweist, muss diese vor der Durchführung des erfindungsgemäßen Verfahrens abgezogen werden.

Die Herstellung des erfindungsgemäßen Flexodruckelementes bietet keinerlei Besonderheiten und kann nach den dem Fachmann prinzipiell bekannten Methoden beispielsweise durch Kneten der Bestandteile und Ausformen der Schicht durch Pressen, mittels Extrusion und Kalandrieren zwischen Trägerfolie und Deckfolie oder durch Aufgießen der gelösten Bestandteile der Schicht auf den dimenssionsstabilen Träger erfolgen.

Das soeben offenbarte Flexodruckelement ist zur konventionellen Bebilderung mittels fotografischer Masken vorgesehen. In einer weiteren Ausführungsform der Erfindung kann es sich auch um ein digital bebilderbares Flexodruckelement handeln. Hierbei weist das Flexodruckelement eine zusätzliche digital bebilderbare Schicht auf. Diese kann sich auf der transparenten Substratschicht befinden, es kann beim Vorhandensein digital bebilderbarer Schichten aber auch auf die Substratschicht verzichtet werden.

Bei der digital bebilderbaren Schicht handelt es sich bevorzugt um eine Schicht ausgewählt aus der Gruppe der IR-ablativen Schichten, Ink-Jet-Schichten oder thermografischen Schichten.

IR-ablative Schichten bzw. Masken sind für die Wellenlänge des aktinischen Lichtes opak und umfassen üblicherweise ein filmbildendes thermisch zersetzbares Bindemittel sowie mindestens einen IR-Absorber wie beispielsweise Ruß. Ruß sorgt auch dafür, dass die Schicht opak ist. Als Bindemittel kommen sowohl organisch löslich Bindemittel wie beispielsweise Polyamide oder Nitrocellulose wie auch wässrig lösliche Bindemittel beispielsweise Polyvinylalkohol oder Polyvinylalkohol / Polyethylenglykol-Propfcopolymere in Betracht. In die IR-ablative Schicht kann mittels eines IR-Lasers eine Maske eingeschrieben werden, d.h. die Schicht wird an den Stellen, an denen sie vom Laserstrahl getroffen wird, zersetzt und abgetragen. Durch die entstandene Maske hindurch kann bildmäßig mit aktinischem Licht bestrahlt werden. Beispiele für die Bebilderung von Flexodruckelementen mit IR-ablativen Masken sind beispielweise in EP-A 654 150 oder EP-A 1 069 475 offenbart.

Bei Ink-Jet-Schichten wird eine transparente, mit Ink-Jet-Tinten beschreibbare Schicht, beispielsweise eine Gelatine-Schicht aufgetragen. Diese ist mittels Ink-Jet-Druckern mit opaken Tinten bedruckbar. Beispiele sind in EP-A 1 072 953 offenbart.

Bei thermografischen Schichten handelt es sich um transparente Schichten, die Substanzen enthalten, die sich unter dem Einfluss von Hitze schwarz färben. Derartige Schichten umfassen beispielsweise ein Bindemittel und ein anorganisches oder organisches Silbersalz und können mittels eines Druckers mit Thermokopf bebildert werden. Beispiele sind in EP-A 1 070 989 offenbart.

Bei der digital bebilderbaren Schicht kann es sich auch um eine sogenannte peel-off-layer handeln, wie beispielsweise von EP-A 654 151 offenbart.

In einer bevorzugten Ausführungsform sind die digital bebilderbaren Schichten in Wasser oder überwiegend wässrigen Lösemittelmischungen löslich.

Die digital bebilderbaren Schichten können auf die fotopolymerisierbare Schicht oder die Substratschicht in prinzipiell bekannter Art und Weise aufgegossen werden.

Zur Durchführung des erfindungsgemäßen Verfahren wird das Flexodruckelement als Ausgangsmaterial eingesetzt. Falls das Flexodruckelement eine Schutzfolie umfasst, wird diese zunächst abgezogen. In den ersten Verfahrensschritten wird das Flexodruckelement bildmäßig bebildert und anschließend in weiteren Verfahrensschritten thermisch entwickelt.

In Verfahrensschritt (a) wird die fotopolymerisierbare reliefbildende Schicht zunächst bildmäßig mittels aktinischer Strahlung belichtet. Die bildmäßige Belichtung kann mittels der prinzipiell bekannten Verfahren erfolgen.

Beim konventionellen Verfahren wird zur Bebilderung der reliefbildenden Schicht im Verfahrensschritt (a) eine fotografische Maske aufgelegt. Anschließend wird das Flexodruckelement durch die aufgelegte Maske hindurch mit aktinischem Licht belichtet.

Als aktinisches, also chemisch "wirksames" Licht eignet sich in bekannter Art und Weise insbesondere UVA- bzw. UV/VIS-Strahlung. Durch die Bestrahlung wird die fotopolymerisierbare Schicht in den nicht abgedeckten Bereichen vernetzt. Um eine störungsfreie Auflage des fotografischen Negativs zu erhalten, kann die Belichtung in bekannter Art und Weise unter Verwendung eines Vakuumrahmens oder unter einer Glasplatte vorgenommen werden.

Falls der dimensionsstabile Träger transparent ist, kann das Flexodruckelement optional in einem (a) vorgelagerten Verfahrensschritt von der Rückseite her mit aktinischem Licht bestrahlt werden. Durch einen solchen Schritt kann die Relieftiefe festgelegt werden und er trägt zu einer besseren Verankerung der Reliefelemente bei.

In den Verfahrensschritten (b) und (c) des erfindungsgemäßen Verfahrens wird das bildmäßig belichtete Flexodruckelement thermisch entwickelt. Die beiden Verfahrensschritte können nacheinander oder auch gleichzeitig durchgeführt werden.

Im Verfahrensschritt (b) wird das Flexodruckelement erwärmt, so dass die nicht polymerisierten Anteile der reliefbildenden Schicht erweichen, verflüssigen oder schmelzen. Dem Fachmann ist bewusst, dass der Begriff "schmelzen" im Hinblick auf die Masse aus Polymer, Monomer, Fotoinitiator sowie gegebenenfalls Weichmacher und anderen Zusätzen nicht so präzise wie bei reinen, niedermolekularen Stoffen definierbar ist. Gemeint ist hier, dass die Viskosität der Masse so weit erniedrigt werden soll, dass sie in Verfahrensschritt (c) von einem Vlies absorbiert oder anderweitig entfernt werden kann.

Das Flexodruckelement wird in Schritt (b) auf eine Temperatur erwärmt, die hoch genug ist, um die nicht polymerisierten Schichtanteile in ausreichendem Maße zu verflüssigen, jedoch ohne die polymerisierten Anteile der Schicht zu beschädigen. Im allgemeinen ist dazu eine Temperatur 40 bis 200°C erforderlich. Bevorzugt wird das Flexodruckelement auf eine Temperatur von 60 bis 160°C erwärmt.

Das Erwärmen kann beispielsweise durch Bestrahlen mit einer Hitzequelle, beispielsweise mittels eines IR-Strahlers, erfolgen. Weitere Beispiele umfassen das Eintauchen in Wärmebäder, das Erhitzen mittels heißer Luft- oder Flüssigkeitsströme oder Kontaktieren des Flexodruckelementes mit heißen Flächen ohne dass die Erfindung darauf beschränkt sein soll. Es kann auch eine Kombination mehrerer Methoden verwendet werden. Bevorzugt wird das Flexodruckelement von der Vorderseite her erwärmt. Hierbei weist die Oberfläche der reliefbildenden Schicht üblicherweise eine höhere Temperatur auf, als die unterhalb der Oberfläche gelegenen Bereiche der Schicht.

In Schritt (c) werden die erweichten, nicht polymerisierten Anteile der reliefbildenden Schicht entfernt. Die polymerisierten Anteile bleiben auf dem Träger zurück wodurch sich das Druckrelief ausbildet.

Schritt (c) kann beispielsweise so vorgenommen werden, indem man die erwärmte reliefbildende Schicht mit einem absorbierenden Material kontaktiert. Die erwärmten, verflüssigten, nicht polymerisierten Anteile der reliefbildenden Schicht werden hierbei vom absorbierenden Material absorbiert. Um eine möglicht effiziente Absorption zu erreichen, sollte ein möglichst inniger Kontakt zwischen dem absorbierenden Material und der Oberfläche des Flexodruckelementes hergestellt werden. Beispielsweise kann das absorbierende Material auf die Oberfläche gelegt und anschließend angedrückt werden. Nach dem Vollsaugen des absorbierenden Materials mit der polymeren Masse wird das absorbierende Material von der noch warmen Flexodruckplatte wieder abgezogen. Um eine möglichst vollständige Entfernung des erweichten Materials zu gewährleisten ist es regelmäßig empfehlenswert, diesen Vorgang mit frischem absorbierenden Material so oft zu wiederholen, bis alles verflüssigte Material entfernt ist. Als absorbierende Materialien eignen sich geeignete poröse Materialien, beispielsweise Vliese aus Nylon, Polyester oder Cellulose. Weitere Details zur Durchführung von Schritt (d) sind in WO 01/88615, Seite 15, Zeile 6 bis Seite 17, Zeile 2 offenbart, auf die wir an dieser Stelle ausdrücklich verweisen.

In einer alternativen Ausführungsform für Verfahrensschritt (b) erfolgt die Entfernung durch Bearbeitung der erwärmten Flexodrukkelementes mit einem heißen Luft- oder Flüssigkeitsstrom unter Druck. Beispielsweise kann das Flexodruckelement mit Wasserdampf unter Druck von der Oberseite her abgestrahlt werden. Der heiße Wasserdampfstrom sorgt einerseits für die Erwärmung des Flexodruckelementes und die Erweichung der nicht polymerisierten Anteile der reliefbildenden Schicht. Die mechanische Energie des Strahles sorgt für die Trennung der verflüssigten Masse von den polymerisierten Anteilen. Weitere Details sind in WO 01/90818 Seite 3, Zeile 5 bis 16 offenbart.

Die durch thermische Entwicklung erhaltene Druckform kann optional auch noch nachbehandelt werden. Sie kann beispielsweise vollflächig mittels aktinischem Licht nachbelichtet werden. Sie kann weiterhin auf prinzipiell bekannte Art und Weise mittels Br₂-Lösung oder mittels Bestrahlung durch UV-C-Licht oberflächlich entklebt werden.

Das erfindungsgemäße Verfahren bei Verwendung von Flexodruckelementen mit digital bebilderbaren Schichten ist dem oben beschriebenen sehr ähnlich. Anstelle der Verwendung einer fotografischen Maske wird im Verfahrensschritt (a) die digital bebilderbare Schicht mittels der jeweils notwendigen Technik bebildert und somit quasi in situ auf der reliefbildende Schicht eine Maske erzeugt.

Bei Verwendung IR-ablativer Masken wird die IR-ablative Schicht mit Hilfe eines IR-Lasers bildmäßig entfernt. Es werden dabei diejenigen Bereiche freigelegt, die später vernetzt werden sollen und die Reliefelemente bilden. Bei Verwendung von Ink-Jet-Schichten oder thermografischen Schichten wird die digital bebilderbare Schicht mittels Ink-Jet- bzw. thermografischen Druckern in denjenigen Bereichen bedruckt, die im Zuge der Bestrahlung nicht vernetzt werden sollen.

Nach dem Erzeugen einer Maske aus der digital bebilderbaren Schicht wird wie bei Verwendung einer fotografischen Maske mittels aktinischem Licht bestrahlt. Ein Vakuumrahmen zur Belichtung ist nicht erforderlich. Vorzugsweise wird mittels eines Flachbettbelichters an Luft belichtet.

Die belichteten Flexodruckelemente können als solche, d.h. inklusive der digital bebilderbaren Schicht oder den Resten davon zur thermischen Entwicklung eingesetzt werden.

In einer bevorzugten Ausführungsform wird die digital bebilderbare Schicht in einem Verfahrensschritt (b) vorgelagerten Verfahrensschritt entfernt. Das vorherige Ablösen der digital bebilderbaren Schicht spart Zeit bei der thermischen Entwicklung und verhindert eine Kontamination des thermischen Verarbeitungsgerätes mit Bestandteilen der Maskenschicht. Die Entfernung der digital bebilderbaren Schicht kann beispielsweise durch Abziehen oder durch Ablösen mittels eines geeigneten Lösemittels geschehen. In einer besonders bevorzugten Ausführungsform wird eine wasserlösliche oder zumindest in Wasser quellbare digital bebilderbare Schicht eingesetzt. Die digital bebilderbare Schicht bzw. die Reste davon können nach der Bebilderung und Bestrahlung mit aktinischem Licht mit Wasser oder überwiegend wässrigen Lösemitteln abgelöst werden. Das Ablösen kann optional durch sanfte mechanische Behandlung, beispielsweise durch Bürsten unterstützt werden. Da die erfindungsgemäß eingesetzten Olefin / (Meth)acrylat-Bindemittel in aller Regel nur in organischen Lösemitteln bzw. Lösemittelgemischen löslich sind, werden die nicht polymerisierten Anteile der reliefbildenden Schicht weder gelöst noch die polymerisierten Anteile aufgequollen. Das so vorbehandelte Flexodruckelement kann daher ohne dass eine Trocknung notwendig wäre direkt im Anschluss weiter verarbeitet werden.

Die erfindungsgemäßen Flexodruckelemente eignen sich gleichermaßen sowohl zur thermischen wie zur konventionellen Entwicklung mittels Auswaschmitteln. Bei der konventionellen Entwicklung wird im Anschluss an das bildmäßige Belichten des Flexodruckelementes das belichtete Flexodruckelement in bekannter Art und Weise mit einem organischen Lösemittel oder Lösemittelgemisch entwickelt.

Die erfindungsgemäßen Flexodruckelemente können weiterhin auch als Ausgangsmaterial zur Herstellung von Flexodruckformen mittels Laser-Direktgravur eingesetzt werden. Hierzu wird ein Flexodrukkelement eingesetzt, welches keine digital bebilderbare Schicht aufweist. Dieses wird in einem ersten Verfahrensschritt vollflächig, d.h. ohne Auflegen einer Maske, mittels aktinischem Licht vernetzt. In die vollflächig vernetzte reliefbildende Schicht kann anschließend mittels eines CO₂-Laser direkt das Druckrelief eingraviert werden. Die vernetzte Schicht wird an den Stellen, an denen Sie vom Laser getroffen wird, thermisch zersetzt. Nähere Einzelheiten zur Technik der Laser-Direktgravur zur Herstellung von Flexodruckformen sind beispielsweise in EP-A 1 136 254 und US 5,259,311 offenbart.

Die erfindungsgemäßen Flexodruckelemente zeichnen sich gegenüber herkömmlichen Flexodruckelementen durch eine Reihe von Vorteilen aus. Sie weisen eine besonders gute Ozonrissbeständigkeit, geringe Quellung auch in UV-Farben, hohe Elastizität, geringe plastische Verformung, gleichbleibend gute Haftung auf dem Träger auch bei hohen Druckauflagen und eine besonders hohe Transparenz der reliefbildenden Schicht auf. Weiterhin können sie besonders ökonomisch mittels Extrusion bei relativ niedrigen Temperaturen hergestellt werden.

Die folgenden Beispiele sollen die Erfindung näher erläutern.

Für die Beispiele wurden die folgenden Materialien eingesetzt:
A) Bindemittel
   - Lotader AX8900:: Statistisches Ethylen-Methylacrylat-Glycidylmethacrylat-Copolymer (25 Gew.-% Methylacrylat, 8 Gew.-% Glycidylmethacrylat, MFI = 6 g/10 min nach ASTM D 1238, Schmelzpunkt 65 °C, von ATOFINA)
   - Lotryl 35MA05:: Statistisches Ethylen-Methylacrylat-Copolymer (35 Gew.-% Methylacrylat, MFI = 4,5 - 5,5 g/10 min nach ASTM D 1238, Schmelzpunkt 50 °C, von ATOFINA)
   - Lotryl 29MA03:: Statistisches Ethylen-Methylacrylat-Copolymer (29 Gew.-% Methylacrylat, MFI = 2 - 3,5 g/10 min nach ASTM D 1238, Schmelzpunkt 61 °C, von ATOFINA)
   - Lotryl 28MA07:: Statistisches Ethylen-Methylacrylat-Copolymer (28 Gew.-% Methylacrylat, MFI = 6 - 8 g/10 min nach ASTM D 1238, Schmelzpunkt 65 °C, von ATOFINA)
   - Lotryl 35BA40:: Statistisches Ethylen-Butylacrylat-Copolymer (35 Gew.-% Butylacrylat, MFI = 35 - 40 g/10 min nach ASTM D 1238, Schmelzpunkt 67 °C, von ATOFINA)
   - Lotryl 24MA07:: Statistisches Ethylen-Methylacrylat-Copolymer (24 Gew.-% Methylacrylat, MFI = 6 - 8 g/10 min nach ASTM D 1238, Schmelzpunkt 73 °C, von ATOFINA)
   - Lotryl 30BA02:: Statistisches Ethylen-Butylacrylat-Copolymer (30 Gew.-% Butylacrylat, MFI = 1,5 - 2,5 g/10 min nach ASTM D 1238, Schmelzpunkt 78 °C, von ATOFINA)
   - Lotryl 20MA08:: Statistisches Ethylen-Methylacrylat-Copolymer (20 Gew.-% Methylacrylat, MFI = 7 - 9 g/10 min nach ASTM D 1238, Schmelzpunkt 80 °C, von ATOFINA)
   - Lotryl 17BA07:: Statistisches Ethylen-Butylacrylat-Copolymer (17 Gew.-% Butylacrylat, MFI = 6,5 - 8 g/10 min nach ASTM D 1238, Schmelzpunkt 91 °C, von ATOFINA)
   - Kraton D-1161:: Styrol-Isopren-Styrol-Blockcopolymer (15 Gew.-% Styrol-Einheiten, Diblock-Anteil = 17 %, von KRATON)
   - Kraton D-1102:: Styrol-Butadien-Styrol-Blockcopolymer (30 Gew.-% Styrol-Einheiten, Diblock-Anteil = 17 %, von KRATON)
B) Weitere Komponenten der reliefbildende Schicht
   - Ondina 934:: Paraffinischer Mineralölweichmacher (von SHELL)
   - Hallstar BST:: Butylstearat (von C.P. HALL)
   - Nisso PB-B 1000:: Polybutadienöl mit einem mittleren Molekulargewicht von ca. 1.050 g/mol (von NIPPON-SODA)
   - Laromer HDDA:: 1,6-Hexandioldiacrylat (von BASF)
   - 1,6-HDDMA:: 1,6-Hexandioldimethacrylat (von DEGUSSA/ROEHM)
   - Laurylacrylat 1214:: Gemisch aus n-Dodecylacrylat und n-Tetradecylacrylat (von BASF)
   - Lucirin BDK: Benzildimethylketal (von BASF)
   - Benzophenon: Benzophenon 99% (von ALDRICH)
   - Kerobit TBK: 2,6-Di-tert.-butyl-p-kresol (von RASCHIG)
   - Toluol: Toluol (von BASF)

### Beispiel 1

Herstellung eines fotopolymerisierbaren Flexodruckelemetes erfindungsgemäßer Zusammensetzung mit einem Ethylen-Methylacrylat-Glycidylmethacrylat-Copolymeren (Ethylengehalt = 87,3 mol.-%, Schmelzpunkt (gemessen mittels DSC) = 65 °C) als Bindemittel.

33,23 g (66,46 Gew.-%) Lotader AX8900 werden in einem 50 ml-Labormesskneter bei einer Vorgabetemperatur von 140°C ca. 2 Minuten vorplastifiziert. Anschließend wird eine Lösung aus 1,0 g (2,00 Gew.-%) Laurylacrylat 1214, 4,0 g (8,00 Gew.-%) Laromer HDDA, 1,0 g (2,00 Gew.-%) Lucirin BDK, 0,25 g (0,50 Gew.-%) Benzophenon, 0,5 g (1,00 Gew.-%) Kerobit TBK und 20 mg (0,04 Gew.-%) eines roten Farbstoffes hinzugefügt. Sobald sich wieder eine homogene Schmelze gebildet hat werden noch 10,0 g (20,00 Gew.-%) Ondina 934 zugegeben. Nach wenigen Minuten hat sich die Schmelze wieder homogenisiert.

Die erhaltene elastomere Mischung wird in kleinere Stücke zerteilt. Durch Pressen zwischen einer 5 µm dick polyamidsubstrierten PET-Schutzfolie und einer haftlackbeschichteten PET-Trägerfolie wird bei 140 °C und 200 bar Druck in einer handelsüblichen Kautschukpresse ein 1,27 mm dickes Flexodruckelement hergestellt. Das erkaltete Flexodruckelement ist homogen und flexibel. Durch Wiederholung des beschriebenen Verfahrens werden weitere Exemplare des Flexodruckelements hergestellt. Vor der weiteren Verarbeitung werden die Flexodruckelemente 3 Tage gelagert.

### Beispiel 2

Herstellung einer Flexodruckplatte erfindungsgemäßer Zusammensetzung mit einem Ethylen-Methylacrylat-Glycidylmethacrylat-Copolymeren (Ethylengehalt = 87,3 mol.-%, Schmelzpunkt = 65 °C) als Bindemittel.

Analog Beispiel 1 wird ein Flexodruckelement durch Kneten der Ausgangskomponenten und Pressen der Knetmasse zwischen zwei PET-Folien hergestellt. Menge und Art der eingesetzten Komponenten können Tabelle 1 entnommen werden. Das erhaltene Flexodruckelement ist homogen und flexibel.

### Beispiel 3

Herstellung einer Flexodruckplatte erfindungsgemäßer Zusammensetzung mit einem Ethylen-Methylacrylat-Glycidylmethacrylat-Copolymeren (Ethylengehalt = 87,3 mol.-%, Schmelzpunkt = 65 °C) als Bindemittel.

Analog Beispiel 1 wird ein Flexodruckelement durch Kneten der Ausgangskomponenten und Pressen der Knetmasse zwischen zwei PET-Folien hergestellt. Menge und Art der eingesetzten Komponenten können Tabelle 1 entnommen werden. Das erhaltene Flexodruckelement ist homogen und flexibel.

### Beispiel 4

Herstellung einer Flexodruckplatte erfindungsgemäßer Zusammensetzung mit einem Ethylen-Methylacrylat-Copolymeren (Ethylengehalt = 85,1 mol.-%, Schmelzpunkt = 50 °C) als Bindemittel.

Analog Beispiel 1 wird ein Flexodruckelement durch Kneten der Ausgangskomponenten und Pressen der Knetmasse zwischen zwei PET-Folien hergestellt. Menge und Art der eingesetzten Komponenten können Tabelle 1 entnommen werden. Das erhaltene Flexodruckelement ist homogen und flexibel.

### Beispiel 5

Herstellung einer harten Flexodruckplatte erfindungsgemäßer Zusammensetzung mit einem Ethylen-Methylacrylat-Copolymeren (Ethylengehalt = 88,3 mol.-%, Schmelzpunkt = 61 °C) als Bindemittel.

Analog Beispiel 1 wird ein Flexodruckelement durch Kneten der Ausgangskomponenten und Pressen der Knetmasse zwischen zwei PET-Folien hergestellt. Menge und Art der eingesetzten Komponenten können Tabelle 1 entnommen werden. Das erhaltene Flexodruckelement ist homogen und flexibel.

### Beispiel 6

Herstellung einer harten Flexodruckplatte erfindungsgemäßer Zusammensetzung mit einem Ethylen-Methylacrylat-Copolymeren (Ethylengehalt = 88,8 mol.-%, Schmelzpunkt = 65 °C) als Bindemittel.

Analog Beispiel 1 wird ein Flexodruckelement durch Kneten der Ausgangskomponenten und Pressen der Knetmasse zwischen zwei PET-Folien hergestellt. Menge und Art der eingesetzten Komponenten können Tabelle 1 entnommen werden. Das erhaltene Flexodruckelement ist homogen und flexibel.

### Beispiel 7

Herstellung einer Flexodruckplatte erfindungsgemäßer Zusammensetzung mit einem Ethylen-Butylacrylat-Copolymeren (Ethylengehalt = 89,5 mol.-%, Schmelzpunkt = 67 °C) als Bindemittel.

Analog Beispiel 1 wird ein Flexodruckelement durch Kneten der Ausgangskomponenten und Pressen der Knetmasse zwischen zwei PET-Folien hergestellt. Menge und Art der eingesetzten Komponenten können Tabelle 1 entnommen werden. Das erhaltene Flexodruckelement ist homogen und flexibel.

### Beispiel 8

Herstellung einer harten Flexodruckplatte erfindungsgemäßer Zusammensetzung mit einem Ethylen-Methylacrylat-Copolymeren (Ethylengehalt = 90,7 mol.-%, Schmelzpunkt = 73 °C) als Bindemittel.

Analog Beispiel 1 wird ein Flexodruckelement durch Kneten der Ausgangskomponenten und Pressen der Knetmasse zwischen zwei PET-Folien hergestellt. Menge und Art der eingesetzten Komponenten können Tabelle 1 entnommen werden. Das erhaltene Flexodruckelement ist homogen und flexibel.

### Beispiel 9

Herstellung einer harten Flexodruckplatte erfindungsgemäßer Zusammensetzung mit einem Ethylen-Butylacrylat-Copolymeren (Ethylengehalt = 91,4 mol.-%, Schmelzpunkt = 78 °C) als Bindemittel.

Analog Beispiel 1 wird ein Flexodruckelement durch Kneten der Ausgangskomponenten und Pressen der Knetmasse zwischen zwei PET-Folien hergestellt. Menge und Art der eingesetzten Komponenten können Tabelle 1 entnommen werden. Das erhaltene Flexodruckelement ist homogen und flexibel.

### Vergleichsbeispiel A

Herstellung einer Flexodruckplatte erfindungsgemäßer Zusammensetzung mit einem Ethylen-Methylacrylat-Copolymeren (Ethylengehalt = 92,5 mol.-%, Schmelzpunkt = 80 °C) als Bindemittel.

Analog Beispiel 1 wird ein Flexodruckelement durch Kneten der Ausgangskomponenten und Pressen der Knetmasse zwischen zwei PET-Folien hergestellt. Menge und Art der eingesetzten Komponenten können Tabelle 1 entnommen werden. Das erhaltene Flexodruckelement ist relativ hart und wenig elastisch. Menge und Art der eingesetzten Komponenten können Tabelle 1 entnommen werden.

### Vergleichsbeispiel B

Herstellung einer Flexodruckplatte nicht erfindungsgemäßer Zusammensetzung mit einem Ethylen-Butylacrylat-Copolymeren (Ethylengehalt = 95,7 mol.-%, Schmelzpunkt = 89 °C) als Bindemittel.

Analog Beispiel 1 wird ein Flexodruckelement durch Kneten der Ausgangskomponenten und Pressen der Knetmasse zwischen zwei PET-Folien hergestellt. Menge und Art der eingesetzten Komponenten können Tabelle 1 entnommen werden. Nach dem Abkühlen bildet sich an der Knetmassenoberfläche ein öliger Film, der durch das Ausschwitzen unverträglicher Rezepturbestandteile verursacht wird. Eine Weiterverarbeitung der Knetmasse zu einem Flexodruckelement ist nicht mehr möglich. Zusätzlich ist die Knetmasse nach dem Erkalten sehr hart und wenig elastisch.

### Vergleichsbeispiel C

Herstellung einer Flexodruckplatte nicht erfindungsgemäßer Zusammensetzung mit einem SIS-Blockcopolymeren (Styrolgehalt = 15 Gew.-%, Diblockanteil = 17 %) als Bindemittel.

Analog Beispiel 1 wird ein Flexodruckelement durch Kneten der Ausgangskomponenten und Pressen der Knetmasse zwischen zwei PET-Folien hergestellt. Menge und Art der eingesetzten Komponenten können Tabelle 1 entnommen werden.

### Vergleichsbeispiel D

Herstellung einer Flexodruckplatte nicht erfindungsgemäßer Zusammensetzung mit einem SBS-Blockcopolymeren (Styrolgehalt = 30 Gew.-%, Diblockanteil = 17 %) als Bindemittel.

Analog Beispiel 1 wird ein Flexodruckelement durch Kneten der Ausgangskomponenten und Pressen der Knetmasse zwischen zwei PET-Folien hergestellt. Menge und Art der eingesetzten Komponenten können Tabelle 1 entnommen werden.

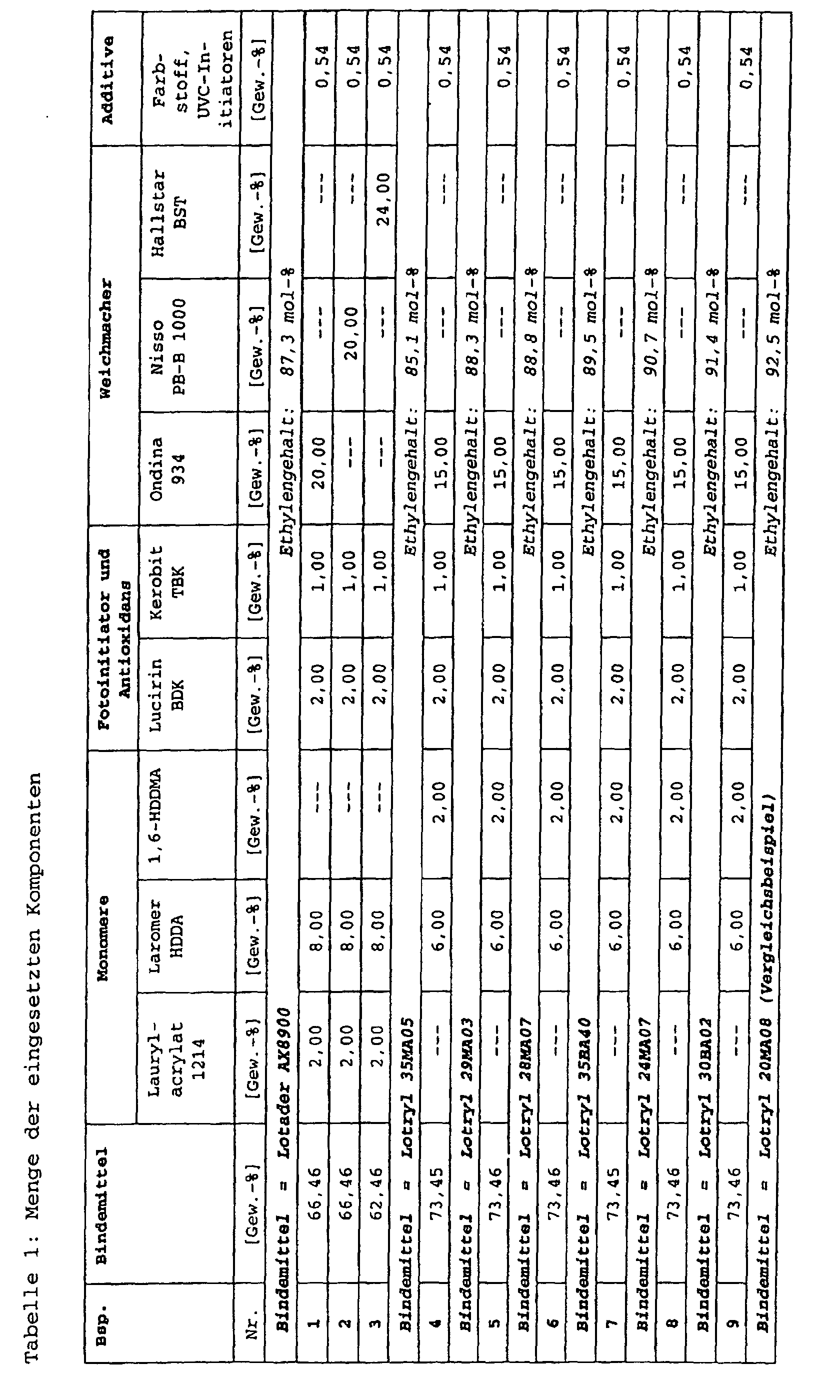

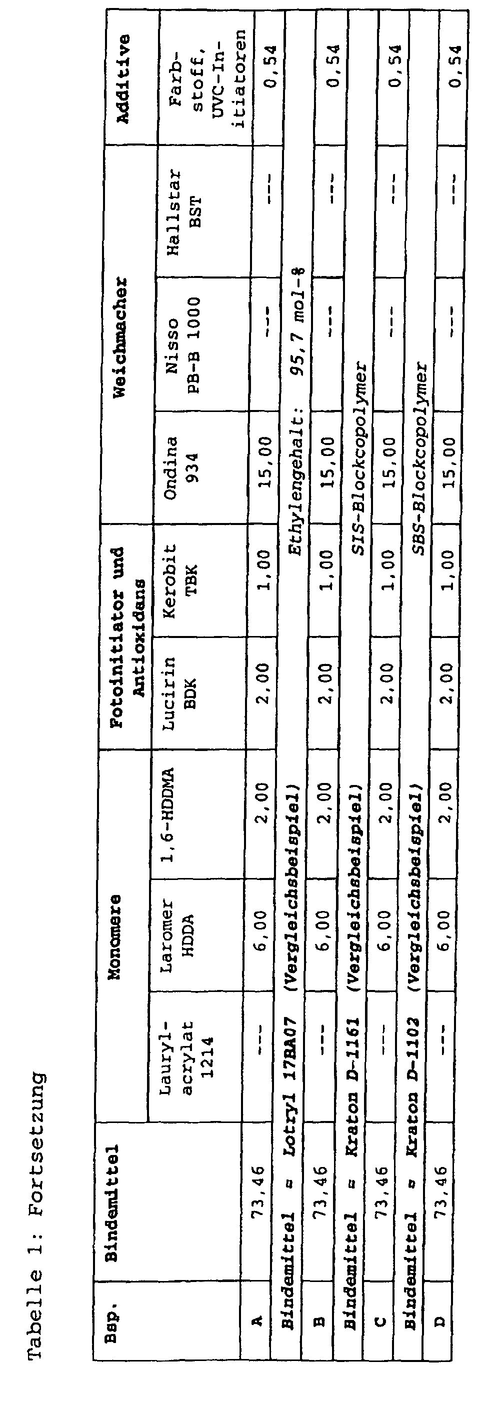

Herstellung von Flexodruckklischees durch thermisches Entwickeln mittels des erfindungsgemäßen Verfahrens

Zur Belichtung der Flexodruckelemente wird ein handelsüblicher Belichter für Flexodruckplatten (nyloflex® F III-Belichter, BASF Drucksysteme GmbH) verwendet.

Zunächst wird die Rückseite der Flexodruckplatten ohne Vakuum für 15 Sekunden vollflächig mit UV/A-Licht bestrahlt. Danach wird die transparente PET-Schutzfolie entfernt und ein Testnegativ auf die Vorderseite der Flexodruckplatte aufgelegt. Die Bestrahlung erfolgt durch ein Testnegativ für verschiedene Hauptbelichtungszeiten von 6 min bis 20 min in Schritten von 2 min unter Vakuum. Hierzu wird eine Vakuumfolie über Negativ und Flexodruckplatte gezogen und eine an das Belichtungsgerät angeschlossene Vakuumpumpe aktiviert. Das Vakuum beträgt ca. 800 mbar).

Nach der Belichtung wird die Druckplatte mit Hilfe einer Versuchsapparatur thermisch verarbeitet. Hierzu werden maximal 15 cm x 15 cm große Stücke der belichteten Druckplatte auf eine motorgetriebene Metallwalze mit einem Durchmesser von 20 cm unter Verwendung von doppelseitigem Klebeband fixiert. Über eine beheizbare Metallwalze mit einem Durchmesser von 5 cm wird ein handelsübliches Polyamid-Vlies geführt. Oberhalb der druckplattentragenden Walze ist ein Infrarotstrahler zur rascheren Erwärmung der Druckplatte befestigt. Nach dem Einschalten des Infrarotstrahlers und Temperierung der beheizbaren Metallwalze auf 150 °C wird die druckplattentragende Metallwalze über den Motor in langsame Drehung versetzt (ca. 2 U/min). Dabei wird das Vlies über die beheizbare Walze unter einem definierten Anpressdruck von etwa 2,5 bar vorbeigeführt. Eine vollständige Umdrehung der druckplattentragenden Walze wird als 1 Zyklus definiert. Insgesamt werden zur Verarbeitung der Druckplatte verschieden viele Zyklen durchlaufen, wobei die Anzahl in der Auswertung unter dem Parameter "Zyklen" angegeben ist.

Abschließend wird die Druckplatte vom doppelseitigen Klebeband gelöst, 10 Minuten vollflächig ohne Vakuum UV/A-nachbelichtet und durch 20-minütige Bestrahlung in einem UV/C-Bestrahlungsgerät entklebt.

Die Abbildungsqualität der thermisch verarbeiteten Flexodruckelemente wird mittels der gleichen Motivelemente wie beim Prozess der konventionellen Verarbeitung vorgenommen. Hierbei wird für die Positivelemente diejenige Belichtungszeit angegeben, bei welcher alle Positivelemente fehlerfrei ausgebildet sind ("LEL" = lower exposure limit).
- Untergrund (= Gleichmäßigkeit und Sauberkeit des Reliefuntergrundes)
- Randschärfe (= Schärfe von Elementrändern, Freiheit von Schmelzrückständen)

In Tabelle 2 sind die entsprechenden, bestimmten Merkmale für die Beispiele 1, 3, 6 und 8 sowie für die Vergleichsbeispiele C und D aufgelistet.

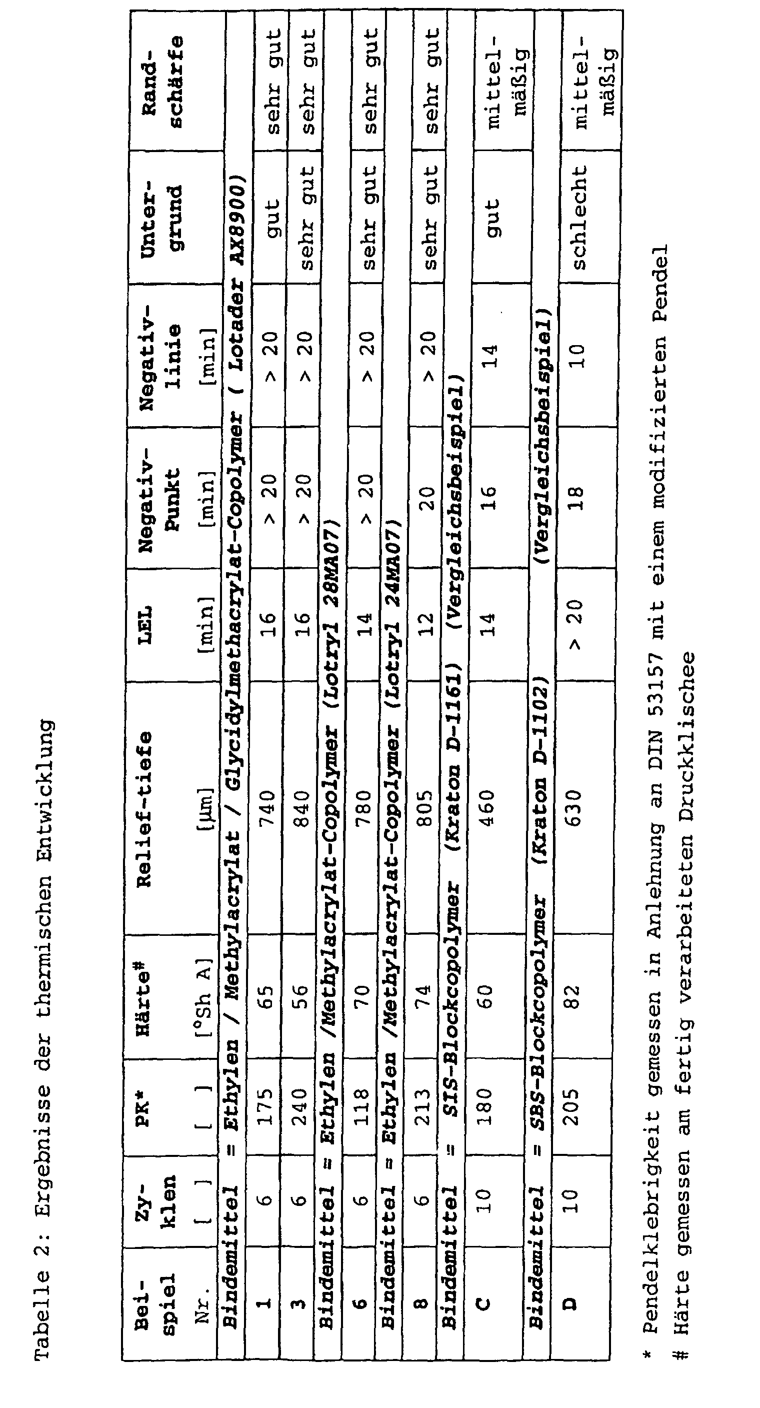

Anhand von Tabelle 2 wird deutlich, dass sich Flexodruckelemente erfindungsgemäßer Zusammensetzung hervorragend thermisch verarbeiten lassen, da bei reduzierter Zyklenzahl bzw. verminderter Zeitdauer der thermischen Verarbeitung gut ausgebildete Positivelemente mit üblichen Belichtungszeiten abgebildet werden können.

Weiterhin sind bei Flexodruckelementen erfindungsgemäßer Zusammensetzung Negativelemente gemessen an den Vergleichsbeispielen C und D bis zu deutlich höheren Belichtungszeiten ausreichend tief, was verhindert, dass auch Motive, die solche Elemente enthalten, ohne die Gefahr von Qualitätsverlusten gedruckt werden können. Auch visuell beurteilt erscheinen die mittels thermischer Verarbeitung hergestellten Flexodruckklischees erfindungsgemäßer Zusammensetzung sehr kantenscharf und gleichmäßig, was eine gleichbleibend hohe Druckqualität auch bei längeren Druckaufträgen garantiert.

Herstellung von Flexodruckklischees (konventionelle Verarbeitung mittels Auswaschmittel.

Die Flexodruchelemente wurden wie bei der thermischen Entwicklung beschrieben bildmäßig belichtet.

Nach der Belichtung wird die Druckplatte in einem handelsüblichen Flexodruckplatten-Durchlaufwascher (Typ Variomat VF2, von BASF Drucksysteme GmbH) mit dem Auswaschmittel (nylosolv II, von BASF Drucksysteme GmbH) ausgewaschen. Die Auswaschgeschwindigkeit wird auf 200 mm/min eingestellt, die Bürstenbeistellung beträgt in allen Fällen 0 mm.

Im Anschluss wird das Klischee 2 Stunden bei 65°C in einem Umlufttrockenschrank getrocknet, 10 Minuten vollflächig ohne Vakuum UV/A-nachbelichtet und durch 20-minütige Bestrahlung in einem UV/C-Bestrahlungsgerät entklebt.

Um die mit den erfindungsgemäßen Flexodruckelementen erzielbare Abbildungsqualität zu beurteilen enthält das Testnegativ verschiedene feine Motivelemente, die optisch bzw. messtechnisch erfasst und ausgewertet werden können. Im einzelnen sind dies die folgenden Elemente, die zusammen mit den zur Qualitätsbeurteilung verwendeten Parametern aufgeführt sind:

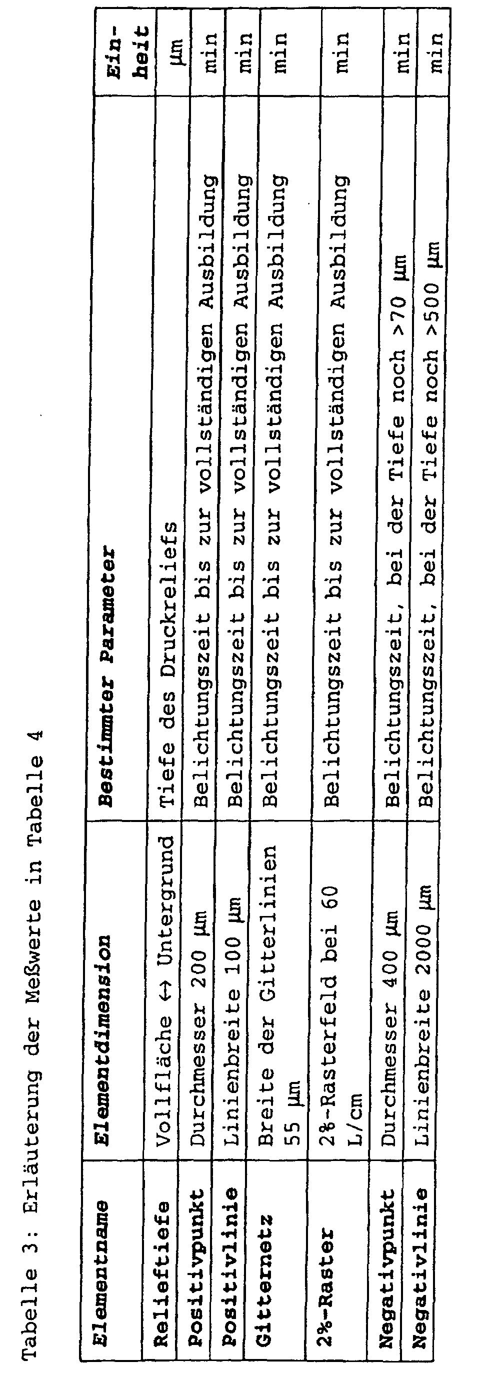

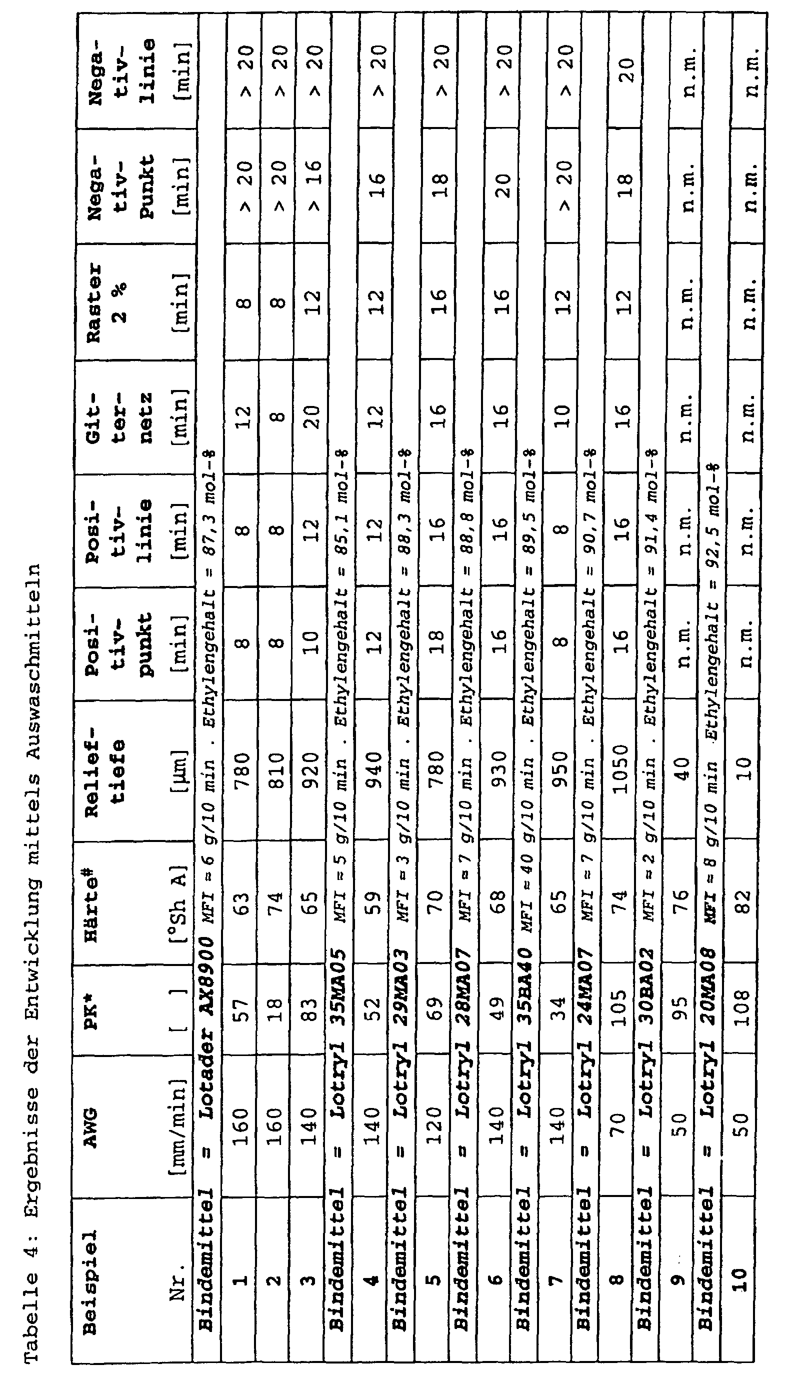

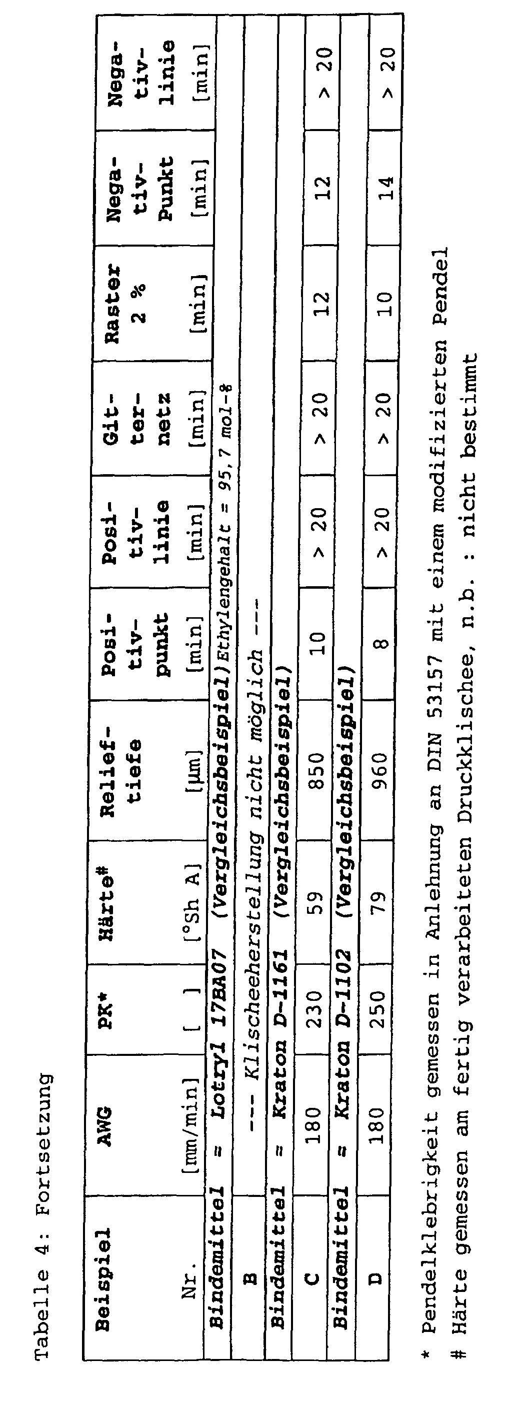

Anhand von Tabelle 4 kann man erkennen, dass die Flexodruckelemente erfindungsgemäßer Zusammensetzung konventionell, d.h. mittels eines lösemittelbasierten Auswaschprozesses und anschlieβendem Trocknen, gut verarbeitet werden können und Druckklischees in hoher Qualität erhalten werden. Insbesondere besitzen Negativelemente eine überdurchschnittlich große Tiefe auch bei längeren Belichtungszeiten, was sich positiv auf die Druckqualität auswirkt.

Die Herstellung eines Flexodruckelements erfindungsgemäßer Zusammensetzung ist nur möglich, wenn der Ethylengehalt der Bindemittel nicht größer als 94 mol-% ist. Ansonsten sind in Flexodruckplatten üblicherweise verwendete Bestandteile wie Monomere und Weichmacher nicht kompatibel mit dem Bindemittel.

Mit abnehmendem Ethylengehalt nimmt die Löslichkeit der Rohschicht in üblichen Flexoauswaschmitteln zu. Bei Bindemitteln mit einem Ethylengehalt zwischen 92 mol-% und 94 mol-% ist eine konventionelle Verarbeitung möglich aber relativ langsam. Solche Flexodruckelemente sind noch relativ hart und nicht optimal flexibel.

Optimale Eigenschaften der erfindungsgemäßen Flexodruckelemente werden bei Ethylengehalten unterhalb von 92 mol-% erzielt. Diese Flexodruckelemente lassen sich gut auswaschen und die fertigen Druckklischees sind weich und flexibel. Die Farbübertragung solcher Flexodruckklischees mit wasserbasierten, alkoholbasierten und UV-härtbaren Druckfarben ist ausgezeichnet, ohne dass es im Laufe des Druckprozesses zu Störungen im Druck kommt.

### Drucktests

Drei Flexodruckelemete mit einer Zusammensetzung gemäß Beispiel 1 wurden durch Zweischneckenextrusion und Kalandrieren zwischen Trägerfolie und Deckfolie hergestellt, mit einem Testmotiv belichtet, bei einer Auswaschgeschwindigkeit von 160 mm/min in einem mit nylosolv II betriebenen Flexowascher entwickelt und 2 Stunden bei 65 °C getrocknet. Im Anschluss an die Nachbehandlung (10 min UV/A-Nachbelichtung und 15 min UV/C-Entklebung) wurde je ein Druckklischee auf einer Andruckmaschine mit einer wasserbasierten, einer alkoholbasierten und einer UV-härtbaren Druckfarbe angedruckt. Die Farbübertragung, die Schärfe des Druckbildes und die Gleichmäßigkeit der Druckqualität über eine Laufzeit von jeweils 3 Stunden war exzellent.

## Patentansprüche

1. Verfahren zur Herstellung von Flexodruckformen durch thermische Entwicklung, bei dem man als Ausgangsmaterial ein fotopolymerisierbares Flexodruckelement einsetzt, welches übereinander angeordnet mindestens umfasst
• einen dimensionsstabilen Träger,
• mindestens eine fotopolymerisierbare reliefbildende Schicht, mindestens umfassend ein elastomeres Bindemittel, ethylenisch ungesättigte Monomere und Fotoinitiator,
und das Verfahren mindestens die folgenden Schritte umfasst:
(a) bildweises Belichten der fotopolymerisierbaren reliefbildenden Schicht mittels aktinischer Strahlung,
(b) Erwärmen des belichteten Flexodruckelementes auf eine Temperatur von 40 bis 200°C,
(c) Entfernen der erweichten, nicht polymerisierten Anteile der reliefbildenden Schicht unter Ausbildung eines Druckreliefs,
**dadurch gekennzeichnet, dass** es sich bei dem elastomeren Bindemittel um ein Olefin/(Meth)acrylat-Copolymer handelt, welches
• 70 bis 92 mol % eines oder mehrerer Olefin-Monomere, ausgewählt aus der Gruppe von Ethylen, Propylen, 1-Buten, Isobuten, 1-menten, 1-Hexen, 1-Hepten oder 1-Octen,
• 8 bis 30 mol % (Meth)acrylat-Monomere, sowie
• 0 bis 5 mol % weiterer Comonomerer
jeweils bezüglich der Gesamtmenge aller einpolymerisierten Monomere aufweist.

2. Verfahren gemäß Anspruch 1, **dadurch gekennzeichnet, dass** man das bildweise Belichten (a) ausführt, indem man eine Maske auf das Flexodruckelement auflegt und durch die aufgelegte Maske hindurch belichtet.

3. Verfahren gemäß Anspruch 1, **dadurch gekennzeichnet, dass** das Flexodruckelement zusätzlich eine digital bebilderbare Schicht aufweist und man Schritt (a) ausführt, indem man die digital bebilderbare Schicht bildmäßig beschreibt und durch die somit erstellte Maske hindurch belichtet.

4. Verfahren gemäß Anspruch 3, **dadurch gekennzeichnet, dass** es sich bei der digital bebilderbaren Maske um eine Maske, ausgewählt aus der Gruppe von IR-ablativen Masken, Ink-Jet-Masken oder thermografischen Masken handelt.

5. Verfahren gemäß Anspruch 3 oder 4, **dadurch gekennzeichnet, dass** man die digital bebilderbare Schicht oder die Reste davon vor Verfahrensschritt (b) von der reliefbildenden Schicht ablöst.

6. Verfahren gemäß Anspruch 5, **dadurch gekennzeichnet, dass** die digital bebilderbare Schicht wasserlöslich ist und man die digital bebilderbare Schicht oder die Reste davon mit Wasser oder einem überwiegend wässrigen Lösemittel ablöst.

7. Verfahren gemäß einem der Ansprüche 1 bis 6, **dadurch gekennzeichnet dass** man die Entfernung der erweichten, nicht polymerisierten Anteile durch Kontaktieren des Flexodruckelementes mit einem absorbierenden Material vornimmt.

8. Verfahren gemäß einem der Ansprüche 1 bis 6, **dadurch gekennzeichnet dass** man die Entfernung der erweichten, nicht polymerisierten Anteile durch Bearbeitung des Flexodruckelementes mit heißen Luft- oder Flüssigkeitsströmen unter Druck vornimmt.

9. Verfahren gemäß einem der Ansprüche 1 bis 8, **dadurch gekennzeichnet, dass** die Temperatur 60 bis 160°C beträgt.

10. Verfahren gemäß einem der Ansprüche 1 bis 9, **dadurch gekennzeichnet, dass** der Olefin-Gehalt des elastomeren Bindemittels 80 bis 90 mol % beträgt.

11. Verfahren gemäß einem der Ansprüche 1 bis 10, **dadurch gekennzeichnet, dass** das elastomere Bindemittel einen Schmelzflussindex MFI (190°C, 2,16 kg) von 1 bis 100 g/10 min aufweist.

12. Verfahren gemäß einem der Ansprüche 1 bis 11, **dadurch gekennzeichnet, dass** es sich um ein Ethylen/(Meth)acrylat-Copolymer handelt.

13. Fotopolymerisierbares Flexodruckelement zur Herstellung von Flexodruckformen mindestens umfassend
• einen dimensionsstabilen Träger,
• mindestens eine fotopolymerisierbare reliefbildende Schicht, mindestens umfassend ein elastomeres Bindemittel, Monomere und Fotoinitiator,
**dadurch gekennzeichnet, dass** es sich bei dem elastomeren Bindemittel um ein Olefin/(Meth)acrylat-Copolymer handelt, welches
• 70 bis 92 mol % eines oder mehrerer Olefin-Monomere, ausgewählt aus der Gruppe von Ethylen, Propylen, 1-Buten, Isobuten, 1-Penten, 1-Hexen, 1-Hepten oder 1-Octen,
• 8 bis 30 mol % (Meth)acrylat-Monomere, sowie
• 0 bis 5 mol % weiterer Comonomerer
jeweils bezüglich der Gesamtmenge aller einpolymerisierten Monomere aufweist.

14. Flexodruckelement gemäß Anspruch 13, welches weiterhin eine eine digital bebilderbare Schicht umfasst.

15. Flexodruckelement gemäß Anspruch 14, **dadurch gekennzeichnet, dass** es sich bei der digital bebilderbaren Maske um eine ausgewählt aus der Gruppe von IR-ablativen Masken, Ink-Jet-Masken oder thermografischen Masken handelt.

16. Flexodruckelement gemäß einem der Ansprüche 13 bis 15, **dadurch gekennzeichnet, dass** der Olefin-Anteil 80 bis 90 mol %, der (Meth)acrylat-Anteil 10 bis 20 mol % und der Anteil weiterer Comonomerer 0 bis 5 mol % beträgt.

17. Flexodruckelement gemäß einem der Ansprüche 13 bis 16, **dadurch gekennzeichnet, dass** das elastomere Bindemittel einen Schmelzflussindex MFI (190°C, 2,16 kg) von 1 bis 100 g/10 min aufweist.

18. Flexodruckelement gemäß einem der Ansprüche 13 bis 18, **dadurch gekennzeichnet, dass** es sich um ein Ethylen/(Meth)acrylat-Copolymer handelt.

19. Verwendung von Flexodruckelementen gemäß einem der Ansprüche 13 bis 18 zur Herstellung von Flexodruckformen durch bildmäßiges Belichten mit aktinischem Licht und Entwickeln.

20. Verwendung gemäß Anspruch 19, **dadurch gekennzeichnet, dass** man die Entwicklung thermisch oder mittels eines geeigneten Auswaschmittels durchführt.

21. Verwendung von Flexodruckelementen gemäß einem der Ansprüche 13 sowie 16 bis 18 zur Herstellung von Flexodruckformen mittels Laser-Direktgravur.

## Claims

1. A process for the production of flexographic printing plates by thermal development, in which the starting material used is a photopolymerizable flexographic printing element which at least comprises, arranged one on top of the other,
• a dimensionally stable substrate,
• at least one photopolymerizable relief-forming layer, at least comprising an elastomeric binder, ethylenically unsaturated monomers and a photoinitiator,
the process comprising at least the following steps:
(a) imagewise exposure of the photopolymerizable relief-forming layer by means of actinic radiation,
(b) heating of the exposed flexographic printing element to a temperature of from 40 to 200°C,
(c) removal of the softened, unpolymerized parts of the relief-forming layer with formation of a printing relief,
wherein the elastomeric binder is an olefin/(meth)acrylate copolymer which has
• from 70 to 92 mol% of one or more olefin monomers selected from the group consisting of ethylene, propylene, 1-butene, isobutene, 1-pentene, 1-hexene, 1-heptene and 1-octene,
• from 8 to 30 mol% of (meth)acrylate monomers, and
• from 0 to 5 mol% of further comonomers,
based in each case on the total amount of all monomers incorporated in the form of polymerized units.

2. A process as claimed in claim 1, wherein the imagewise exposure (a) is carried out by placing a mask on the flexographic printing element and effecting exposure through the positioned mask.

3. A process as claimed in claim 1, wherein the flexographic printing element additionally has a digitally imagable layer and step (a) is carried out by writing imagewise on the digitally imagable layer and exposing it through the mask thus prepared.

4. A process as claimed in claim 3, wherein the digitally imagable mask is a mask selected from the group consisting of IR-ablative masks, inkjet masks and thermographic masks.

5. A process as claimed in claim 3 or 4, wherein the digitally imagable layer or the residues thereof is or are detached from the relief-forming layer before process step (b).

6. A process as claimed in claim 5, wherein the digitally imagable layer is water-soluble and the digitally imagable layer or the residues thereof is or are detached using water or a predominantly aqueous solvent.

7. A process as claimed in any of claims 1 to 6, wherein the removal of the softened, unpolymerized parts is carried out by bringing the flexographic printing element into contact with an absorbent material.

8. A process as claimed in any of claims 1 to 6, wherein the removal of the softened, unpolymerized parts is carried out by processing the flexographic printing element using hot air or liquid streams under superatmospheric pressure.

9. A process as claimed in any of claims 1 to 8, wherein the temperature is from 60 to 160°C.

10. A process as claimed in any of claims 1 to 9, wherein the olefin content of the elastomeric binder is from 80 to 90 mol%.

11. A process as claimed in any of claims 1 to 10, wherein the elastomeric binder has a melt flow index MFI (190°C, 2.16 kg) of from 1 to 100 g/10 min.

12. A process as claimed in any of claims 1 to 11, wherein the elastomeric binder is an ethylene/(meth)acrylate copolymer.

13. A photopolymerizable flexographic printing element for the production of flexographic printing plates, at least comprising
• a dimensionally stable substrate,
• at least one photopolymerizable relief-forming layer, at least comprising an elastomeric binder, monomers and a photoinitiator,
wherein the elastomeric binder is an olefin/(meth)acrylate copolymer which has
• from 70 to 92 mol% of one or more olefin monomers selected from the group consisting of ethylene, propylene, 1-butene, isobutene, 1-pentene, 1-hexene, 1-heptene and 1-octene,
• from 8 to 30 mol% of (meth)acrylate monomers, and
• from 0 to 5 mol% of further comonomers,
based in each case on the total amount of all monomers incorporated in the form of polymerized units.

14. A flexographic printing element as claimed in claim 13, which furthermore comprises a digitally imagable layer.

15. A flexographic printing element as claimed in claim 14, wherein the digitally imagable mask is one selected from the group consisting of IR-ablative masks, inkjet masks and thermographic masks.

16. A flexographic printing element as claimed in any of claims 13 to 15, wherein the olefin content is from 80 to 90 mol%, the (meth)acrylate content from 10 to 20 mol% and the content of further comonomers from 0 to 5 mol%.

17. A flexographic printing element as claimed in any of claims 13 to 16, wherein the elastomeric binder has a melt flow index MFI (190°C, 2.16 kg) of from 1 to 100 g/10 min.

18. A flexographic printing element as claimed in any of claims 13 to 17, wherein the elastomeric binder is an ethylene/(meth)acrylate copolymer.

19. The use of a flexographic printing element as claimed in any of claims 13 to 18 for the production of flexographic printing plates by imagewise exposure to actinic light and development.

20. The use as claimed in claim 19, wherein the development is carried out thermally or by means of a suitable washout composition.

21. The use of a flexographic printing element as claimed in any of claims 13 and 16 to 18 for the production of flexographic printing plates by means of direct laser engraving.

## Revendications

1. Procédé pour la préparation de formes flexographiques par développement thermique, dans lequel on utilise comme matière première un élément flexographique photopolymérisable qui comporte au moins, disposés l'un au-dessus de l'autre
• un support stable en dimensions,
• au moins une couche photopolymérisable formant un relief, au moins comportant un liant élastomère, des monomères éthyléniquement insaturés et un photo-initiateur,
et le procédé comprend au moins les étapes suivantes:
(a) l'éclairement selon un mode image de la couche photopolymérisable formant un relief au moyen d'un rayonnement actinique,
(b) le chauffage de l'élément flexographique éclairé, à une température de 40 à 200°C,
(c) l'élimination des parties ramollies, non-polymérisées, de la couche formant un relief, avec formation d'un relief d'impression,
**caractérisé par le fait qu'**il s'agit, en ce qui concerne le liant élastomère, d'un copolymère d'oléfine/ (méth)acrylate, qui présente
• 70 à 92 % en moles d'un ou plusieurs monomères oléfiniques, choisis dans le groupe de l'éthylène, le propylène, le 1-butène, l'isobutène, le 1-pentène, le 1-hexène, le 1-heptène ou le 1-octène,
• 8 à 30 % en moles de monomères de (méth)acrylate, ainsi que
• 0 à 5 % en moles d'autres comonomères
à chaque fois par rapport à la quantité totale de tous les monomères copolymérisés.

2. Procédé selon la revendication 1, **caractérisé par le fait qu'**on réalise la couche (a) selon une image en plaçant un masque sur l'élément flexographique et en éclairant à travers le masque déposé.

3. Procédé selon la revendication 1, **caractérisé par le fait que** l'élément flexographique présente en outre une couche apte à être convertie en image par voie numérique, et on réalise la couche (a) en traitant selon une image la couche apte à donner une image par voie numérique et en éclairant à travers le masque ainsi réalisé.

4. Procédé selon la revendication 3, **caractérisé par le fait qu'**il s'agit pour le masque apte à donner une image par voie numérique d'un masque choisi dans le groupe des masques ablatifs par IR, des masques de jet d'encre ou des masques thermographiques.

5. Procédé selon la revendication 3 ou 4, **caractérisé par le fait qu'**on sépare la couche apte à donner une image par voie numérique ou les restes de celle-ci de la couche formant un relief avant l'étape opératoire (b).

6. Procédé selon la revendication 5, **caractérisé par le fait que** la couche apte à former une image par voie numérique est hydrosoluble et qu'on sépare la couche apte à former une image par voie numérique ou les restes de celle-ci avec de l'eau ou un solvant majoritairement aqueux.

7. Procédé selon l'une des revendications 1 à 6, **caractérisé par le fait qu'**on effectue la séparation des parties ramollies, non-polymérisables par mise en contact de l'élément flexographique avec un matériau absorbant.

8. Procédé selon l'une des revendications 1 à 6, **caractérisé par le fait qu'**on effectue la séparation des parties ramollies, non-polymérisables par traitement de l'élément flexographique avec des courants chauds d'air ou de liquide sous pression.

9. Procédé selon l'une des revendications 1 à 8, **caractérisé par le fait que** la température est de 60 à 160°C.

10. Procédé selon l'une des revendications 1 à 9, **caractérisé par le fait que** la teneur en oléfine du liant élastomère est de 80 à 90 % en moles.

11. Procédé selon l'une des revendications 1 à 10, **caractérisé par le fait que** le liant élastomère présente un indice d'écoulement à l'état fondu MFI (190°C, 2,16 kg) de 1 à 100 g/10 min.

12. Procédé selon l'une des revendications 1 à 11, **caractérisé par le fait qu'**il s'agit d'un copolymère d'éthylène/ (méth)acrylate.

13. Elément flexographique photopolymérisable pour la préparation de formes flexographiques au moins comportant
• un support stable en dimensions,
• au moins une couche photopolymérisable formant un relief, au moins comportant un liant élastomère, des monomères éthyléniquement insaturés et un photo-initiateur,
**caractérisé par le fait qu'**il s'agit, en ce qui concerne le liant élastomère, d'un copolymère d'oléfine/(méth)acrylate, qui présente
• 70 à 92 % en moles d'un ou plusieurs monomères oléfiniques, choisis dans le groupe de l'éthylène, le propylène, le 1-butène, l'isobutène, le 1-pentène, le 1-hexène, le 1-heptène ou le 1-octène,
• 8 à 30 % en moles de monomères de (méth)acrylate, ainsi que
• 0 à 5 % en moles d'autres comonomères
à chaque fois par rapport à la quantité totale de tous les monomères copolymérisés.

14. Elément flexographique selon la revendication 13, qui comporte en outre une couche apte à former une image par voie numérique.

15. Elément flexographique selon la revendication 14, **caractérisé par le fait qu'**il s'agit pour le masque apte à former une image par voie numérique d'un masque choisi dans le groupe des masques ablatifs par IR, des masques de jet d'encre ou des masques thermographiques.

16. Elément flexographique selon l'une des revendications 13 à 15, **caractérisé par le fait que** la partie oléfine représente 80 à 90 % en moles, la partie (méth)acrylate 10 à 20 % en moles et la partie des autres comonomères 0 à 5 % en moles.

17. Elément flexographique selon l'une des revendications 13 à 16, **caractérisé par le fait que** le liant élastomère présente un indice d'écoulement à l'état fondu MFI (190°C, 2,16 kg) de 1 à 100 g/10 min.

18. Elément flexographique selon l'une des revendications 13 à 17, **caractérisé par le fait qu'**il s'agit d'un copolymère d'éthylène/ (méth)acrylate.

19. Utilisation d'éléments flexographiques selon l'une des revendications 13 à 18 pour la préparation de formes flexographiques par éclairement selon une image avec une lumière actinique et développement.

20. Utilisation selon la revendication 19, **caractérisée par le fait que** le développement est effectué par voie thermique ou au moyen d'un agent d'enlèvement par lavage approprié.

21. Utilisation d'éléments flexographiques selon l'une des revendications 13, ainsi que 16 à 18 pour la préparation de formes flexographiques au moyen d'une gravure directe au laser.
